(19) Europäisches Patentamt
European Patent Office
Office européen des brevets

(11) **EP 2 504 725 B1**

(12) **EUROPÄISCHE PATENTSCHRIFT**

(45) Veröffentlichungstag und Bekanntmachung des Hinweises auf die Patenterteilung:
**21.06.2017 Patentblatt 2017/25**

(21) Anmeldenummer: **10763729.0**

(22) Anmeldetag: **15.10.2010**

(51) Int Cl.:
***G02B 5/18*** *(2006.01)*

(86) Internationale Anmeldenummer:
**PCT/EP2010/065492**

(87) Internationale Veröffentlichungsnummer:
**WO 2011/054651 (12.05.2011 Gazette 2011/19)**

(54) **VERFAHREN UND VORRICHTUNG ZUR HERSTELLUNG EINER FRESNEL-ZONENPLATTE**

PROCESS AND APPARATUS FOR PRODUCING A FRESNEL ZONE PLATE

PROCÉDÉ ET DISPOSITIF POUR FABRIQUER UNE PLAQUE À ZONES DE FRESNEL

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **26.10.2009 DE 102009050688**
**11.03.2010 DE 102010010937**

(43) Veröffentlichungstag der Anmeldung:
**03.10.2012 Patentblatt 2012/40**

(73) Patentinhaber: **Max-Planck-Gesellschaft zur Förderung der Wissenschaften e.V.**
**80539 München (DE)**

(72) Erfinder:
- **SCHÜTZ, Gisela**
  **75449 Wurmberg (DE)**
- **GRÉVENT, Corinne**
  **73760 Ostfildem (DE)**
- **MAYER, Marcel**
  **70376 Stuttgart (DE)**
- **BARETZKY, Brigitte**
  **74078 Heilbronn (DE)**

(74) Vertreter: **Hannke, Christian**
**Hannke Bittner & Partner**
**Patent- und Rechtsanwälte mbB**
**Prüfeninger Straße 1**
**93049 Regensburg (DE)**

(56) Entgegenhaltungen:
**WO-A2-2004/012236 JP-A- 1 003 602**
**US-A- 2 679 474 US-A- 5 257 132**
**US-A- 5 382 342 US-A- 5 719 915**
**US-B1- 7 365 918**

- **GERRY TRIANI ET AL: "<title>Atomic layer deposition of TiO<formula><inf><roman>2</roman></inf></formula> / Al<formula><inf><roman>2</roman></inf></formula>O<formula><inf><roman>3</roman></inf></formula> films for optical applications</title>", OPTICAL SENSING II, vol. 5870, 18 August 2005 (2005-08-18), page 587009, XP055270341, 1000 20th St. Bellingham WA 98225-6705 USA ISSN: 0277-786X, DOI: 10.1117/12.638039 ISBN: 978-1-62841-971-9**
- **LIU CHIAN ET AL: "Depth-graded multilayers for application in transmission geometry as linear zone plates", JOURNAL OF APPLIED PHYSICS, AMERICAN INSTITUTE OF PHYSICS, US, vol. 98, no. 11, 13 December 2005 (2005-12-13), pages 113519-113519, XP012077912, ISSN: 0021-8979**

EP 2 504 725 B1

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

## Beschreibung

Die Erfindung betrifft ein Verfahren und eine Vorrichtung zur Herstellung einer Fresnel-Zonenplatte, welches/welche nach erfolgtem Aufbringen von aufeinanderfolgenden Schichten das Herstellen einer Mehrzahl von Fresnel-Zonenplatten ermöglicht.

Die Röntgenmikroskopie hat sich als komplementäre Charakterisierungsmethode zu Licht- und Elektronenmikroskopie bewährt. Der Abbildung von Objekten mit Röntgenstrahlung sind durch die Fokussieroptik Grenzen gesetzt. Die Fresnel-Zonenplatte ist bislang eine der beliebtesten und erfolgreichsten Fokussiereinrichtungen zur Fokussierung von Röntgenstrahlen. Sowohl die Optimierung der Auflösung derartiger Fresnel-Zonenplatten als auch eine Vereinfachung ihres Fertigungsprozesses werden angestrebt.

Es ist bekannt, dass vor dem Hintergrund einer raschen Entwicklung von Technologien im Nanometerbereich und deren bedeutenden Auswirkung für die Entwicklung der Wissenschaften insbesondere für Anwendungen in der Biologie, der Chemie, der Werkstoff- bis hin zu den Umwelt- und biomedizinischen Wissenschaften eine weitere Verbesserung von geeigneten Analysewerkzeugen im Nanometerbereich sehr gewünscht ist.

Die Röntgenmikroskopie kombiniert chemische Selektivität mit hoher räumlicher sowie zeitlicher Auflösung.

Zudem ermöglicht die Röntgenmikroskopie die gleichzeitige Nutzung von anderen röntgenbasierten Verfahren, die die Untersuchung von physikalischen, magnetischen, chemischen und strukturellen Eigenschaften von Stoffen im Mikro- und Nanometerbereich möglich machen. Hierbei reichen die Möglichkeiten von der Mikrospektroskopie, z.B. der μXANES, der mikrochemischen Analyse, des magnetischen Röntgenzirkulardichroismus (XMCD) bis hin zu zeitlich aufgelöster Mikroskopie. Ein weiterer Vorteil ist der geringe Aufwand bei der Präparation der Proben im Vergleich zur Transmissionselektronenmikroskopie. Beispielsweise muss nicht, wie bei der Elektronenmikroskopie, eine derart dünne Probe vorab erstellt werden, was oft zur Zerstörung oder Beschädigung des Probenmaterials führt. Häufig wird deshalb die Röntgenmikroskopie auch in der Biowissenschaft verwendet.

Die potentielle räumliche Auflösung der Röntgenmikroskopie liegt in der Größenordnung der Wellenlänge des verwendeten Lichts. Beim Betrieb des Röntgenmikroskops mit weicher Röntgenstrahlung (Wellenlänge von 0,5 bis 10 nm, Energie von 120 eV - 2 keV), passt die Photonenenergie zu den K-Absorptionskanten von leichten Elementen und ein sehr guter Kontrast zwischen organischem Material und Wasser sowie eine gute Eindringtiefe in mikrometerdicke Proben wird erreicht. Beim Betrieb mit härterer Röntgenstrahlung wird der Zugriff auf die K-Absorptionskanten von mittelschweren und auf die L- und M-Absorptionskanten von schweren Elementen ermöglicht. Die größere Eindringtiefe in diesem Energiebereich erlaubt zudem die Untersuchung von dickeren Proben.

Von entscheidender Bedeutung für die Leistungsfähigkeit und die Wirksamkeit von Röntgenstrahlen in der Röntgenmikroskopie sind die Röntgenlinsen. Da Röntgenstrahlen nur sehr schwach mit Materie, also den zu untersuchenden Proben, in Wechselwirkung treten, können zwar, zum einen vorteilhaft Tomographiestudien durchgeführt und dicke Materialien untersucht werden, jedoch zum anderen eine Fokussierung dieser Röntgenstrahlen nur sehr schwierig durchgeführt werden. Die Verbesserung von Röntgenlinsen bleibt nach wie vor eine große Herausforderung. Für die Fokussierung durch Röntgenlinsen sind sowohl die Brechung als auch die Reflexion und die Beugung von Röntgenstrahlen angewendet worden. Bislang sind die besten Fokussiereigenschaften bei Fresnel-Zonenplatten, also auf Basis von Beugung der Röntgenstrahlen, erzielt worden.

Eine Fresnel-Zonenplatte besteht aus einer Vielzahl aufeinanderfolgender, konzentrischer Ringe, auch Zonen genannt, bei denen sich röntgenabsorbierendes und -transparentes Material abwechseln. Zonenplatten wenden konstruktive Interferenz von Röntgenstrahlen aus benachbarten Zonen an, um einen Brennpunkt zu erzeugen. Die Brennweite f einer Zonenplatte ist eine Funktion ihres Durchmessers, der Dicke der äußersten Zone $\Delta r$ und der Wellenlänge der verwendeten Röntgenstrahlung. Die Auflösung der Zonenplatte steht in enger Beziehung zu der Dicke der äußersten Zone $\Delta r$. Hierbei ist die so genannte Rayleigh-Auflösung auf 1,22 $\Delta r$ beschränkt.

Das Auflösungsvermögen von Fresnel-Zonenplatten (FZP) ist noch nicht an seine physikalisch erreichbaren theoretischen Grenzen gelangt, da sich die Fertigung von Zonen mit niedrigen Dicken mit den bislang eingesetzten Herstellungsverfahren nach wie vor als schwierig gestaltet.

Als weiterer Aspekt bei der Herstellung von Fresnel-Zonenplatten ist der Wirkungsgrad zu betrachten. Der theoretische Wirkungsgrad von aus miteinander abwechselnden, absorbierenden und transparenten Ringen bestehenden Standard-Fresnel-Zonenplatten, sogenannten Amplitudenzonenplatten, ist in der ersten Ordnung auf ungefähr 10 % beschränkt. Andere Zonenplattentypen weisen zwar einen höheren Wirkungsgrad auf, es scheint jedoch, dass eines der Hauptprobleme, sowohl von Standard-Fresnel-Zonenplatten als auch von alternativen Strukturen in der Schwierigkeit liegt, aufgrund von Einschränkungen bei den Fertigungsprozessen die theoretisch vorhergesagten Wirkungsgrade zu erreichen.

Die Höhe bzw. das Aspektverhältnis der Zonenplatte ist eine der wichtigen Größen, die bei der Bestimmung von geeigneten Fertigungsverfahren für Fresnel-Zonenplatten zu berücksichtigen sind. Im Allgemeinen und insbesondere für Amplitudenzonenplatten, die bei hohen Energien eingesetzt werden, müssen die Zonenplatten ein hohes Aspektverhältnis aufweisen. Je höher die Energie der zu fokussierenden Röntgenstrahlen ist, umso größer ist auch die optimale Höhe der Zonenplatte, die zur Fokussierung erforderlich ist. Aufgrund der Tatsache, dass man an technische Grenzen bei den derzeitigen Fertigungsverfahren stößt, gestaltet sich die Fertigung von Zonenplatten mit hohem Aspektverhältnissen nach wie vor als sehr schwierig.

Zusammengefasst sind folgende wichtige Aspekte bei den Problemen zur Herstellung von Zonenplatten zu beachten: Die Auflösung, der Wirkungsgrad, das Aspektverhältnis und der Aufwand des Fabrikationsprozesses. Ein zuverlässiger Fabrikationsprozess, der die Herstellung von Fresnel-Zonenplatten mit sowohl dünnen bis sehr dünnen äußersten Zonen als auch hohen Aspektverhältnissen ermöglicht, wird angestrebt.

Die derzeit zur Erzeugung von hochauflösenden Fresnel-Zonenplatten verwendeten Technologien kommen häufig aus dem Bereich der Elektronenstrahllithographie. Bei diesen Verfahren wird im Wesentlichen ein Zonenplattenmuster in einen Resist (Elektronenstrahl empfindlicher Lack) geschrieben, wodurch nach dessen Entwicklung eine Form gebildet wird, die dann durch Galvanisierung mit Metall gefüllt wird. Das anschließende Entfernen des Resists ergibt die Zonenplatte.

Eine andere allgemein bekannte Technik zur Fertigung von Fresnel-Zonenplatten ist das so genannte "Sputter-sliced"-Verfahren: bei diesem Verfahren werden dünne Schichten von absorbierendem und transmittierendem Material abwechselnd auf einen rotierenden Draht aufgebracht, wodurch sich das geeignete Zonenplattenmuster ergibt. Der beschichtete Draht oder Teile davon können anschließend auf die erforderliche Dicke geschliffen und poliert werden.

Das auf Lithographie basierende Verfahren ist bezüglich der Auflösung eines der bislang beliebtesten Verfahren zur Fertigung von Zonenplatten. Es ermöglicht hohe Auflösungen bei dünnsten äußersten Zonen. Diesem Verfahren sind jedoch, bedingt durch Elektronenstrahldurchmesser und -streuung im Elektronenstrahl-Resist gewisse Grenzen gesetzt. Die Erzielung von höheren Auflösungen, insbesondere die Übertragung von Zonen mit sehr geringer Strukturbreite, ist bis jetzt weder gelungen noch ist geklärt, ob sich solche Strukturen mit Hilfe von Elektronenstrahllithographie übertragen lassen.

Es sind verschiedene Verfahren vorgeschlagen worden, um die eingeschränkte Auflösung zu verbessern. Beispielsweise ist bei dem "Double Patterning"-Überlagerungsverfahren eine recht hohe Auflösung möglich, jedoch ist hier eine hoch präzise Ausrichtungstechnik erforderlich, die das Verfahren zeit- und kostenintensiv macht. Das "Zone Doubling"-Verfahren, bei dem Lithographie und Dünnschichtabscheidungsverfahren kombiniert werden, ermöglicht es, Teststrukturen mit höheren Auflösungen herzustellen, verringert jedoch in beträchtlichem Ausmaß den Wirkungsgrad der Linse, da es die Abscheidung eines röntgenabsorbierenden Materials über die gesamte Zonenplatte hinweg erforderlich macht.

Es hat sich herausgestellt, dass das "Sputter Sliced"-Verfahren verglichen mit dem Lithographie-Verfahren eine beschränkte Genauigkeit bezüglich der Auflösung aufweist und sich nicht für den Aufbau von hochauflösenden Fresnel-Zonenplatten eignet, weswegen es selten verwendet wird.

Zusammengefasst ist gemäß dem Stand der Technik zu beachten:

- In Bezug auf die Auflösung von Fresnel-Zonenplatten insbesondere für den weichen Röntgenbereich, werden bisher beste Ergebnisse mit dem Elektronenstrahllithographie-Verfahren, erreicht.
- Der Wirkungsgrad von Fresnel-Zonenplatten ist theoretisch begrenzt und ist in der Praxis durch Ungenauigkeiten der unterschiedlichen Herstellungsverfahren, die zu fehlerhaften Zonen führen können, weiter beschränkt. Alternative Zonenplatten-Strukturen, die eine höhere Effizienz aufweisen, sind mit den bisher bekannten Herstellungsmethoden nur schwer realisierbar.
- Hohe Aspektverhältnisse sind für hochauflösende Fresnel-Zonenplatten, die in einem hohen Energiebereich eigesetzt werden sollen, erforderlich. Die derzeitigen Elektronenstrahllithographie- Verfahren sind hierbei beschränkt einsetzbar. Folglich gestalten sich hohe Auflösungen für harte Röntgenstrahlung als schwierig.
- das Elektronenstrahllithographie-Verfahren zeigt sich zurzeit als eine der bevorzugten Methoden für die Herstellung von FZP mit hohem Auflösungsvermögen. Die weitere Verbesserung der Auflösung wird jedoch nur mit einem erheblichen Mehraufwand erreicht.

Das Aufbringen von Schichten mittels ALD (Atomic Layer Deposition) auf Si02-Oberflächen ist aus US7365918 bekannt. Bei dem Substrat handelt es sich um ein Silikonsubstrat, auf das lediglich eine dünne Schicht Si02 aufgebracht wird, um die Substratrauheit zu verringern.

Demzufolge ist es Aufgabe der Erfindung, ein Verfahren und eine Vorrichtung zur Herstellung einer Fresnel-Zonenplatte zur Verfügung zu stellen, welches eine einfache und kostengünstige Herstellung einer Fresnel-Zonenplatte, die eine hohe Auflösung, geringe Schichtdicken, ein hohes Aspektverhältnis und fehlerfreie Schichten/Zonen aufweist, ermöglicht. Diese Aufgabe wird verfahrensseitig durch die Merkmale des Patentanspruches 1 und vorrichtungsseitig durch die Merkmale des Patentanspruches 14 gelöst.

Ein wesentlicher Punkt der Erfindung liegt darin, dass das erfindungsgemäße Verfahren zur Herstellung einer Fresnel-Zonenplatte folgende Schritte umfasst:

- Zurverfügungstellung eines bezüglich seiner Mittelachse, vorzugsweise Längsmittelachse, rotationssymmetrischen, vorzugsweise länglichen, Substrats;
- Aufbringen von aufeinander folgenden Schichten mittels einem Atomic Layer Deposition (ALD); Verfahrens auf Flächen, vorzugsweise des Substrates ohne Rotation des Substrates zur Bildung eines beschichteten, vorzugsweise länglichen, Substrates;
- Abtrennen mindestens einer Scheibe von dem beschichteten, vorzugsweise länglichen, Substrat, indem das beschichtete Substrat senkrecht zu der Mittelachse, insbesondere, Längsmittelachse, mindestens einmal geteilt wird.

Durch ein derartiges erfindungsgemäßes Herstellungsverfahren wird eine einfache Herstellung von Fresnel-Zonenplatten ermöglicht, da bei dem Herstellungsverfahren keine Rotation des Substrates zur Bildung eines beschichteten länglichen Substrates notwendig ist. Vielmehr wird mittels des ALD-Verfahrens ermöglicht, dass zum einen rotationsfrei gearbeitet werden kann und zum anderen sehr dünne Schichten zur Bildung einer hohen Auflösung der erhaltenen Fresnel-Zonenplatten erhalten werden. Denn je dünner die Schichten der Fresnel-Zonenplatten sind, desto besser ist die Auflösung. Dies betrifft insbesondere die äußerste Schicht, also die zuletzt aufgetragene Schicht des beschichteten länglichen Substrates bei außenseitig aufgetragenen Schichten. Bei innenseitig aufgetragenen Schichten ist dies die zuerst aufgetragene Schicht des beschichteten Substrates.

Vorraussetzung für eine gute Qualität der Fresnel-Zonenplatten, die in Form von Scheiben von dem länglichen Substrat herunter geschnitten werden, ist eine glatte Oberfläche des Substrates mit einer geringen Oberflächenrauigkeit und eine geringe Abweichung in der Symmetrie des Substrats bezüglich der Längsmittelachse .

Derartig hergestellte Fresnel-Zonenplatten können zudem ein hohes Aspektverhältnis aufweisen und können bei hohen Röntgenenergien eingesetzt werden. Dies trifft beispielsweise auf die Verwendung der Fresnel-Zonenplatten mit harter Röntgenstrahlung zu. Die hierbei erhaltenen Auflösungswerte der Fresnel-Zonenplatten können bei 5-100 nm, vorzugsweise bei 15 nm und niedriger liegen.

Durch die Verwendung eines ALD-Verfahrens zur Aufbringung der einzelnen Schichten, die sich zumeist kreisförmig um das Substrat bezüglich des Querschnittes des beschichteten Substrates befinden, wird eine präzise Kontrolle der Schichtdicke und der Schichtzusammensetzung ermöglicht. Dies wird durch die Anwendung des Atomlagenabscheidungs-Verfahrens, welches der Atomic Layer Deposition entspricht, ermöglicht. Zudem werden hierdurch sehr dünne Schichten zum Erhalt eines hohen Aspektverhältnisses und einer hohen Auflösung gewonnen.

Es ist durch die Verwendung des ALD-Verfahrens zudem möglich, Schichten mit Schichtdicken von nur wenigen Nanometern und darunter aufzubringen. Die äußerste Zone bzw. Schicht kann beispielsweise eine Schichtdicke von wenigen Nanometer aus einem Bereich, nämlich beispielsweise von 5-100 nm, bevorzugter 5-30 nm, vorzugsweise unter 15 nm oder sogar bis zu 1 nm, aufweisen, woraus sich ein erheblicher Vorteil gegenüber dem bisher bekannten Standard Elektronenstrahllithographie-Verfahren ergibt.

Zudem wird es nicht notwendig, dass wie bei dem Standard-"Sputter-Sliced"-Verfahren eine Rotation des Substrates während des Aufbringens der Schichten durchgeführt wird. Vielmehr kann hierdurch eine mechanische Vibration des Substrates verhindert werden, welches zu einem besseren Qualitätsergebnis der einzelnen Schichten und somit zu Zonenstrukturen mit weniger Fehlern führt. Dies hat wiederum eine vorteilhafte Wirkung hinsichtlich einer besseren Auflösung und einem besseren Wirkungsgrad, der somit näher an den theoretisch erreichbaren Wert rückt.

Die Verwendung des ALD-Verfahrens bietet eine vielfältige Materialauswahl für die Schichten. Diese Schichtmaterialien und gegebenenfalls Materialzusammensetzungen lassen sich in ihren Zusammensetzungsverhältnissen exakt kontrollieren. Es kann für jede einzelne Atomlage entschieden werden, welches Material aufgebracht wird. Dadurch wird der Weg zur Anfertigung von Fresnel-Zonenplatten mit hochgenau kontrollierten Strukturen geebnet. Beispielsweise können hierdurch in ihrer Form aus dem Stand der Technik bekannte Kinoform-Zonenplatten mit einem theoretischen Wirkungsgrad von 100 % auf einfache Weise realisiert werden.

Gemäß einer bevorzugten Ausführungsform wird als längliches Substrat ein zylinderförmiges Element, wie ein Draht, verwendet. Bei Verwendung eines derartigen Drahtes wird die Außenfläche mit den einzelnen Schichten mittels des ALD-Verfahrens versehen.

Alternativ kann beispielsweise ein zylinderförmiges Element verwendet werden, welches in Richtung seiner Längsmittelachse eine mittig angeordnete Durchgangsöffnung, beispielsweise in Form einer Bohrung, aufweist. Derartige zylinderförmige Elemente können innenseitig, also an den Wänden der Durchgangsöffnung, mit den einzelnen Schichten versehen werden. Alternativ oder zusätzlich können Außenwände eines derartigen zylinderförmigen Elementes mit Schichten versehen werden.

Das längliche Substrat kann als kegelförmiges oder kegelstumpfförmiges Element ausgebildet sein. Ebenso können sämtliche andere symmetrische dreidimensionale Formen verwendet werden. Beispielsweise kann im Querschnitt betrachtet ein Ellipsoid als längliches Substrat verwendet werden. Ebenso sind längliche Substrate, die in ihren Querschnitt eine runde Form aufweisen, jedoch unterschiedliche Durchmesser im Längsverlauf des Substrates aufzeigen, denkbar. Auch die Verwendung einer Kugelform oder eines Abschnittes hiervon für die Form des Substrates ist denkbar.

Die aufeinanderfolgenden Schichten des zylinder-, kegel- oder kegelstumpfförmigen Elementes werden zusammen mit dem Substrat scheibenweise senkrecht zur Längsmittelachse abgeschnitten. Hierbei können Scheiben mit sehr geringen Scheibendicken, wie beispielsweise aus einem Bereich von wenigen 100 nm bis 10 $\mu$m abgetrennt werden. Hierfür werden herkömmliche Schneidwerkzeuge, Trennwerkzeuge, herkömmliche Trennverfahren oder auch ein FIB-Verfahren (Focused Ion Beam- oderfokussierter Ionenstrahl) verwendet.

Auf diese Weise kann mittels eines einmalig stattfindenden Herstellungsverfahrens ein beschichtetes längliches Substrat erzeugt werden, welches eine Vielzahl von einzelnen Fresnel-Zonenplatten, also von abgetrennten Scheiben, zur Folge hat.

Die abgetrennten Scheiben werden durch Schleif-/ oder Poliervorgänge in ihrer Scheibendicke reduziert, um das gewünschte Scheibendickenmaß zu erhalten.

Die abgetrennte Scheibe wird auf ein weiteres Substrat aufgebracht, um dann in fixierter Form als Fresnel-Zonenplatte eingesetzt werden zu können. Die äußerste Schicht weist vorteilhaft eine Schichtdicke aus einem Bereich von 5 -100 nm, bevorzugter 5-30 nm, vorzugsweise von unter 15 nm bis zu 1 nm auf. Die Zonenbreiten einer Zonenplatte für eine Verwendung bei 1200 eV mit beispielsweise einem Gesamtdurchmesser von 38 $\mu$m und einer äußersten Zonenbreite von 35 nm variieren von außen nach innen von 35nm bis 477 nm.

Als Substrat wird Glas verwendet.

Selbstverständlich lassen sich auch sämtliche anderen Materialien, die die Eigenschaft von einer geringen Oberflächenrauigkeit und geringen Abweichungen in der Rotationssymmetrie aufweisen, verwenden.

Eine Vorrichtung zur Durchführung des Verfahrens, wie oben beschrieben, weist vorteilhaft eine Abtrenneinrichtung oder Schneideinrichtung auf, die die einzelnen Scheiben von dem länglichen Substrat abtrennt bzw. abschneidet. Ebenso sind eine Vorrichtung zur Anwendung des Atomic Layer Deposition-Verfahrens und eine Vorrichtung zum Festhalten ohne Durchführung einer Rotation von dem Substrat während des Aufbringens der einzelnen Schichten durch das ALD-Verfahren vorhanden.

Zusätzlich kann eine Vorrichtung zum Polieren bzw. Abschleifen der einzelnen abgetrennten Scheiben zur Herbeiführung einer gewünschten Scheibendicke der Scheiben verwendet werden.

Es können - wie bereits erwähnt - eine Vielzahl von Fresnel-Zonenplatten aus einem einzelnen Substrat herausgeschnitten werden, abhängig davon, wie lang dieses Substrat, beispielsweise in Form eines Drahtes, ausgebildet ist. Durch das Inscheibenschneiden von beschichteten Substraten kann für den Fall der Verwendung eines Drahtes eine größer angelegte Produktion an Fresnel-Zonenplatten durchgeführt werden. Nach dem Aufbringen der einzelnen Schichten auf dem Draht können viele Fresnel-Zonenplatten scheibenweise abgeschnitten werden. Dadurch wird das hier verwendete Fertigungsverfahren effizient und relativ einfach verglichen mit dem Elektronenstrahllithographie-Verfahren. Im Falle der Verwendung der Elektronenstrahllithographie ist die Fertigungsausbeute relativ gering, da viele Fresnel-Zonenplatten hergestellt werden müssen, um einige davon mit der gewünschten fokussierenden Wirkung zu erhalten. Somit ist die erfindungsgemäße Herstellung der Fresnel-Zonenplatten kostengünstig und effizient.

Weitere vorteilhafte Ausführungsformen ergeben sich aus den Unteransprüchen.

Vorteile und Zweckmäßigkeiten sind der nachfolgenden Beschreibung mit der Zeichnung zu entnehmen.

Hierbei zeigen:

Fig. 1 in einer ersten Querschnittsdarstellung ein beschichtetes längliches Substrat zur Herstellung einer Vielzahl von Fresnel-Zonenplatten gemäß dem erfindungsgemäßen Verfahren;

Fig. 2 in einer Querschnittsdarstellung ein zweites beschichtetes längliches Substrat zur Herstellung einer Vielzahl von Fresnel-Zonenplatten gemäß dem erfindungsgemäßen Verfahren;

Fig. 3 in einer Querschnittsdarstellung ein beschichtetes längliches Substrat zur Herstellung einer Vielzahl von Fresnel-Zonenplatten gemäß dem erfindungsgemäßen Verfahren;

Fig. 4 eine Vollfeld röntgenmikroskopische Abbildung eines beschichteten zylinderförmigen Substrates im Querschnitt:

Fig. 5 eine REM-Aufnahme (Raster Elektronen Mikroskopie) eines Ausschnittes der Schichten von einem beschichteten Substrat gemäß dem erfindungsgemäßen Verfahren; und

Fig. 6 eine REM-Aufnahme eines beschichteten Drahtes während eines Abtrennvorganges.

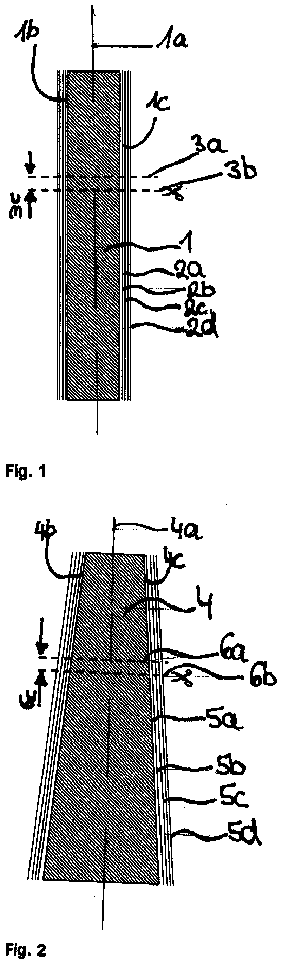

In Fig. 1 wird in einer Querschnittsdarstellung eine erste Ausführungsform der Erfindung mit einem Substrat in zylinderförmiger Form, wie es ein Draht darstellt, wiedergegeben. Gemäß Fig. 1 weist ein Draht 1 eine Längsmittelachse 1a auf und gemäß dieser Querschnittsdarstellung eine linke Außenwand 1 b und eine rechte Außenwand 1 c, wobei die Außenwände 1 b und 1 c Abschnitte eines Zylindermantels sind.

Ein derartiges Substrat 1 weist ebenso wie die Substrate der nachfolgenden Ausführungsformen eine nahezu ideale Rotationssymmetrie um deren optische Achse bzw. Längsmittelachse 1a auf. Dies bedeutet, dass das Substrat, beispielsweise mit einem Durchmesser von ca. 30 μm, eine Rundheit bezüglich der Längsmittelachse mit einer Abweichung von weniger als 25-50 nm besitzt. Hierbei wird die Rundheit als Abweichung von einem idealen Kreis definiert: Wenn der Kreis nicht ideal ist und zu einer Ellipse mit einer a- und einer b-Achse ausgebildet ist so gilt für die Rundheit:

$$\text{Rundheit} = a - b$$

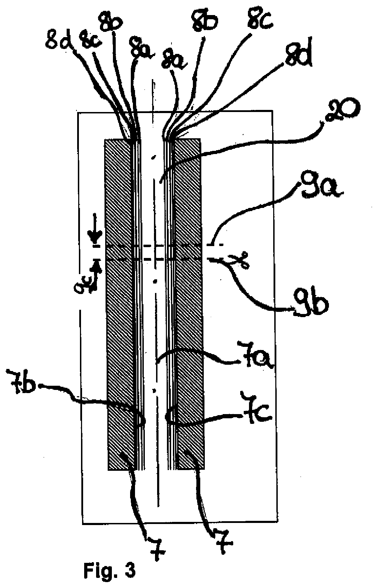

Eine nahezu ideale Symmetrie bezüglich der optische Achse bzw. Längsmittelachse des verwendeten Substrates ist erforderlich um optische Aberrationen zu vermeiden. Abweichungen bei der Platzierung der Zonen bzw. Schichten haben nämlich schwerwiegende Folgen für den Wirkungsgrad der Fresnel-Zonenplatten. Die verschiedenen möglichen Platzierungsungenauigkeiten in Verbindung mit dem Fertigungsverfahren sind Elliptizität, Nicht-Konzentrizität und Radialverschiebung. Sie führen jeweils zu den folgenden Aberrationen: Astigmatismus, Koma und sphärische Aberrationen. Hohe Präzisionsanforderungen werden deshalb als notwendig erachtet, um gute Fokussiereigenschaften für die Fresnel-Zonenplatten zu erlangen. Ebenso können Kegel, Ellipsoide oder beliebige andere achsensymmetrische Substrate wie z. B. eine Kugel aus Glas verwendet werden. Beispielsweise kann eine Kegelstumpfform gemäß Fig. 2 oder eine zylinderförmige Form mit einer in Längsmittelachsenrichtung betrachtete Durchgangsöffnung gemäß Fig. 3 verwendet werden.

In Fig. 1 sind die einzelnen aufgebrachten Schichten mittels der Bezugszeichen 2a - 2d dargestellt. Die erste Schicht 2a wird zuerst aufgetragen anschließend mittels des ALD-Verfahrens die Schicht 2b dann die Schicht 2c und abschließend die Schicht 2d aufgetragen. Die tatsächliche Anzahl und Dicke der einzelnen Schichten wird durch die Zonenplatten-Formel vorgegeben und beträgt typischerweise 100 bis mehrere hundert Schichten.

Ein anschließendes Trennverfahren, wie es durch die beiden Scherenschnitte 3a und 3b angedeutet wird, bringt den länglich geformten Zylinder, welcher das beschichtete Substrat darstellt, in einzelne Scheibenformen, die dann nach erfolgter Polierung oder einem erfolgten Schleifvorgang die Fresnel-Zonenplatte darstellen. Eine Vielzahl von Trennungen gemäß der lediglich stilistisch angedeuteten Trennschnitte 3a und 3b führt zu einer Vielzahl von Fresnel-Zonenplatten, die sich aus einem derartigen länglich beschichteten Substrat 1 ergeben.

Das in Fig. 2 wiedergegebene kegelstumpfförmige Substrat 4 weist ebenso Außenwände 4b und 4c auf, die Abschnitte eines Kegelstumpfmantels darstellen, da in Fig. 2 ein Querschnitt wiedergegeben wird. Die Längsmittelachse 4a zeigt die Symmetrie dieser Kegelstumpfform.

Die Schichten 5a - 5d werden in der Reihenfolge 5a, 5b, 5c und 5d ohne Rotation mittels des ALD-Verfahren aufgetragen.

Anschließend findet eine Durchtrennung des beschichteten länglichen Substrates gemäß den stilistisch angeordneten Schnittstellen 6a und 6b statt, um hierdurch eine oder eine Vielzahl von Scheiben zu erhalten, die aufgrund der Kegelstumpfform des Substrates Fresnel-Zonenplatten mit unterschiedlichen Durchmesser und geneigten Zonen liefern und somit gegebenenfalls einen anderen Einsatzzweck der hieraus erhaltenen Zonenplatten hinsichtlich deren Fokussierbarkeit, deren Auflösung und dergleichen haben können.

Die Scheiben weisen vorzugsweise eine Höhe von wenigen Mikrometern bis zu wenigen 100 Nanometern auf. Dies entspricht der Scheibendicke.

Derartig hergestellte Fresnel-Zonenplatten haben keine natürliche Obergrenze in Bezug auf das Aspektverhältnis. Nachdem die Schichten auf dem Substrat aufgebracht worden sind, ist die Höhe bzw. Scheibendicke der Scheibe, die aus dem Substrat herausgeschnitten werden kann so hoch, wie sie benötigt wird: Es gibt demzufolge keine Begrenzung nach oben und somit nahezu keine Begrenzung des Aspektverhältnisses. Da die Vorbereitung von Zonenplatten für eine hohe Auflösung beabsichtigt ist, bedarf es zum einen eines Schneid- und Dünnungsprozesses, der die feine Schichtstruktur nicht beschädigt und zum anderen Schichten, die sich dafür eignen, in Scheiben geschnitten zu werden. Hierbei hat sich gezeigt, dass das Verfahren mit fokussiertem Ionenstrahl (FIB) ein geeignetes Verfahren ist, um die Fresnel-Zonenplatten in Scheiben zu schneiden und zu dünnen. Demzufolge wird eine derartige Abtrennung bzw. Schneidvorrichtung eine Ionenstrahltrennvorrichtung darstellen.

Es wurde ebenso herausgefunden, dass das abwechselnde Aufbringen von Schichten aus $Ta_2O_5$ und $Al_2O_3$ auf einem Glasdraht, wie er in Fig. 1 schematisch dargestellt wird, zu einer widerstandsfähigen Endbeschichtung führt, die ein weiteres in Scheiben schneiden und dünnen des beschichteten Substrats auf einfache Weise zulässt.

Hierbei ist $Ta_2O_5$ als röntgenabsorbierendes und $Al_2O_3$ als röntgentransparentes Material mit einer hervorragenden Gleichmäßigkeit hinsichtlich seiner Verteilung und einer guten Präzision hinsichtlich seiner Schichtdicke mittels dem ALD-Verfahren vorgesehen. Vorteilhaft werden beispielsweise über 100 Schichten aus $Ta_2O_5$ und $Al_2O_3$ mit äußersten Schichtdicken in einem Bereich von 5 - 100 nm auf das oben erwähnte Substrat aufgebracht.

Es ist möglich, das oben erwähnte Substrat, nämlich einen Glasdraht mit alternierender Beschichtung aus $Ta_2O_5$ und $Al_2O_3$, durch das folgende Verfahren in Scheiben zu schneiden und zu dünnen.

Nachdem die Schichten mittels Atomlagenabscheidung (ALD) auf der Faser bzw. auf dem Draht aufgebracht worden sind, wird die beschichtete Glasfaser in ein Zweistrahlinstrument, welches eine Kombination aus einer Anordnung mit fokussiertem Ionenstrahl und einem Rasterelektronenmikroskop ist, übertragen, in welchem folgende Bearbeitungsschritte durchgeführt werden:

- die äußeren Schichten werden durch Aufbringen von Platin geschützt;
- eine Scheibe mit einer Breite von etwa 5 μm wird mit dem fokussierten Ionenstrahl herausgeschnitten;
- die Scheibe wird mithilfe eines Mikromanipulators (Omniprobe) auf eine Trägerstruktur (TEM-Gitter) übertragen und mit Platin darauf fixiert;
- die Scheibe wird in der Anordnung mit fokussiertem Ionenstrahl gedünnt bzw. geschmälert, also in ihrer Dicke reduziert: Es kann hierbei eine Dicke von weniger als 600 nm erzielt werden, ohne dass dabei die empfindliche Schichtstruktur zerstört wird.
- Im Zentrum der Fresnel-Zonenplatte wird mittels fokussiertem Ionenstrahl eine kreisscheibenförmige röntgenstrahlungsundurchlässige Blende aufgebracht.

Alternativ zu dem Glasdraht kann gemäß Fig. 3 ein Röhrchen oder eine Kapillare verwendet werden, wobei die Aufbringung der Schichten innenseitig an den Wänden der Durchgangsöffnung 20 stattfindet. Auch in diesem Fall findet keine Rotation des Substrates 7 statt. Die Innenwände des Substrates 7 werden mit 7b und 7c bezeichnet. Die Längsmittelachse wird mit 7a bezeichnet.

Die einzelnen Schichten werden durch die Bezugszeichen 8a - 8d wiedergegeben. Selbstverständlich ist das Substrat 7 zylinderförmig aufgebaut. In Fig. 3 wird lediglich ein Querschnitt hiervon dargestellt.

Nach erfolgter Beschichtung findet wiederum ein Trennvorgang statt, der schematisch gemäß in Bezugszeichen 9a und 9b wiedergegeben wird. Hierbei sollen einzelne Scheiben erzeugt werden, die eine Schichtdicke 9c aufweisen, welche in einem anschließenden Schmälerungsverfahren reduziert werden kann. Die Schichtdicken der in Fig. 1 und 2 wiedergegebenen Scheiben, welche aus den darin dargestellten Substraten hergestellt werden sollen, werden mit 3c und 6c dargestellt.

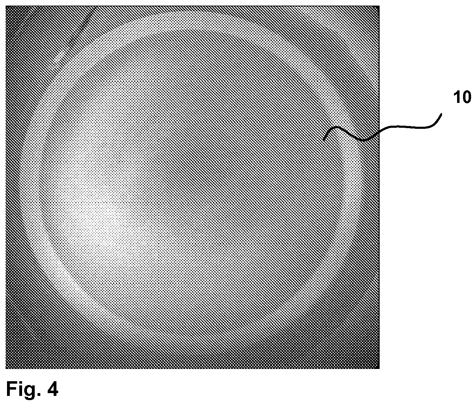

Aus Fig. 4 ist ein Glasdraht 10 im Querschnitt dargestellt. Hierbei handelt es sich um eine Röntgenmikroskopaufnahme. Der Darstellung ist zu entnehmen, dass eine Abweichung von der optimalen Rundheit sehr gering ist, also unter 25 - 50 nm entspricht bei einem Durchmesser von ca. 30 μm.

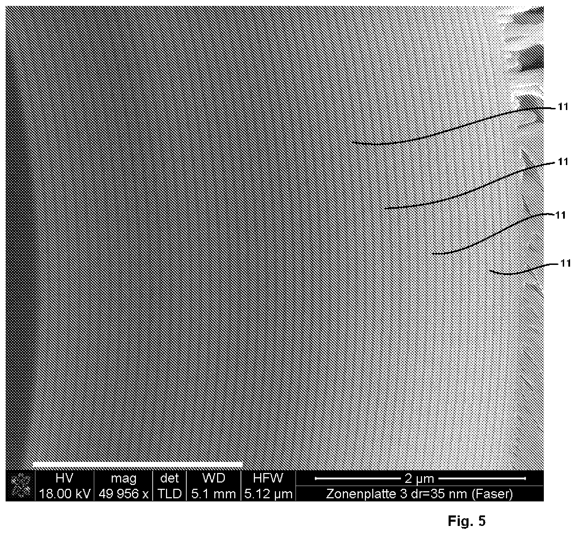

In Fig. 5 ist ein Ausschnitt der einzelnen aufgetragenen Schichten 11 mittels eines REM-Bildes wiedergegeben. Dieser Darstellung ist zu entnehmen, dass die Schichten über die komplette Beschichtungsbreite scharfe und glatte Grenzflächen ausweisen.

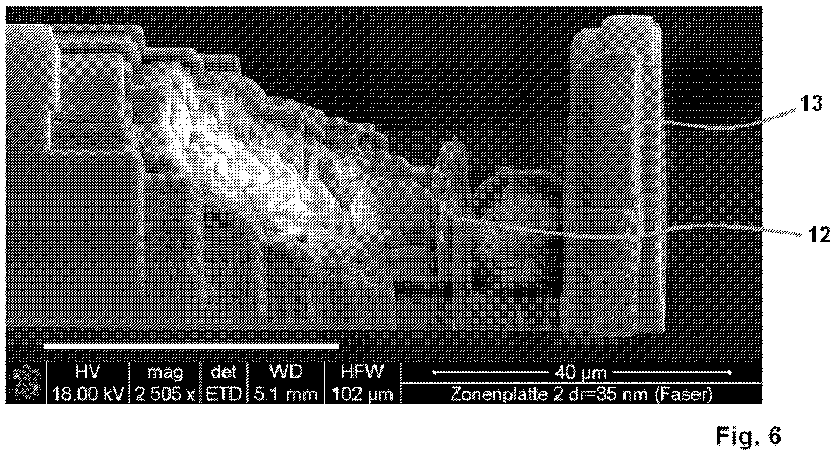

In Fig. 6 wird in einem REM-Bild eine Seitenansicht des Drahtes während des Abtrennvorganges dargestellt. 12 bezeichnet den Schnitt und 13 zeigt die abzutrennende Scheibe (Fresnel-Zonenplatte).

Das erfindungsgemäße Herstellungsverfahren und die erfindungsgemäße Vorrichtung ist dazu verwendbar, Fresnel-Zonenplatten zu erzeugen, die sowohl für harte als auch für weiche Röntgenstrahlung mit einer hohen Auflösung, einem hohen Aspektverhältnis und mit einer geringen Fehlerquote verwendet werden können.

Sämtliche in den Anmeldungsunterlagen offenbarten Merkmale werden als erfindungswesentlich beansprucht, sofern sie einzeln oder in Kombination gegenüber dem Stand der Technik neu sind.

**Bezugszeichenliste**

| | |
|---|---|
| 1, 4, 7 | Draht, Substrat |
| 1a, 4a, 7a | Längsmittelachse |
| 1b, 1c, 4b, 4c | Außenwände |
| 2a, 2b, 2c, 2d | Beispiel Darstellung mittels ALD aufgetragenen Schichten |
| 5a, 5b, 5c, 5d | Beispiel Darstellung mittels ALD aufgetragenen Schichten |
| 8a, 8b, 8c, 8d | Beispiel Darstellung mittels ALD aufgetragenen Schichten |
| 3a, 3b, 6a, 6b | Schnitte |
| 11 | Schichten |
| 9a, 9b, 12 | Schnitte |
| 7b, 7c | Innenwände |
| 3c, 6c, 9c | Schichtdicken |
| 10 | Glasfaser |
| 13 | abgetrennte Scheibe |

**Patentansprüche**

1. Verfahren zur Herstellung einer Fresnel-Zonenplatte (15), umfassend:

   - Zurverfügungstellen eines Substrates (1, 4, 7);
   - Aufbringen von aufeinanderfolgenden Schichten (2a - d; 5a - d; 8a - d; 11) mittels einem Atomic Layer Deposition (ALD)-Verfahren auf Flächen(1 b - c; 4b - c; 7b - c) des Substrates (1, 4, 7) ohne Rotation des Substrates (1, 4, 7) zur Bildung eines beschichteten Substrates;

   wobei das Substrat (1, 4, 7) bezüglich seiner Längsmittelachse (1a, 4a, 7a) rotationssymmetrischen zur Verfügung gestellt wird;
   und die Anzahl und Dicke der einzelnen Schichten durch die Zonenplatten-Formel vorgegeben ist und 100 bis mehrere hundert Schichten beträgt und die äußerste Schicht eine Schichtdicke von aus einem Bereich von 5 - 30 nm, vorzugsweise unter 15 nm oder sogar bis zu 1 nm, aufweist

**dadurch gekennzeichnet, dass**
das Substrat (1, 4, 7) aus Glas ist; und ein Abtrennen (3a, b; 6a, b; 9a, b) einer Vielzahl von Scheiben (13) von dem beschichteten Substrat (1, 4, 7) erfolgt, indem das beschichtete Substrat (1, 4, 7) senkrecht zu der Längsmittelachse (1a, 4a, 7a) mehrfach geteilt wird.

**2.** Verfahren nach Anspruch 1,
**dadurch gekennzeichnet, dass**
als Substrat ein längliches Substrat (1, 4, 7), dessen Längsmittelachse (1a, 4a, 7a) die Mittelachse darstellt, verwendet wird, wobei die Flächen Längsseiten (1 b-c; 4b-c; 7b-c) des länglichen Substrates darstellen.

**3.** Verfahren nach Anspruch 2,
**dadurch gekennzeichnet, dass**
als längliches Substrat ein zylinderförmiges Element (1, 7) verwendet wird.

**4.** Verfahren nach Anspruch 3,
**dadurch gekennzeichnet, dass**
das zylinderförmige Element (7) in Richtung seiner Längsmittelachse (7a) eine mittig angeordnete Durchgangsöffnung (20) aufweist.

**5.** Verfahren nach Anspruch 2,
**dadurch gekennzeichnet, dass**
als längliches Substrat ein kegelförmiges oder kegelstumpfförmiges Element (4) verwendet wird.

**6.** Verfahren nach einem der Ansprüche 3 - 5,
**dadurch gekennzeichnet, dass**
die aufeinander folgenden Schichten (2a - d; 5a - d) auf das zylinderförmige oder kegelförmige oder kegelstumpfförmige Element (1, 4) außenseitig aufgebracht werden.

**7.** Verfahren nach Anspruch 4,
**dadurch gekennzeichnet, dass**
die aufeinanderfolgenden Schichten (8a - d) auf das zylinderförmige Element (7) mit der Durchgangsöffnung (20) innenseitig entlang von Wänden (7b, 7c) der Durchgangsöffnung (20) aufgebracht werden.

**8.** Verfahren nach Anspruch 1,
**dadurch gekennzeichnet, dass**
als Substrat eine Kugel oder ein Abschnitt hiervon verwendet wird.

**9.** Verfahren nach einem der vorangegangenen Ansprüche,
**dadurch gekennzeichnet, dass**
die abgetrennte Scheibe (13) durch Schleif-und/oder Poliervorgänge in ihrer Scheibendicke (3c, 6c, 9c) reduziert wird.

**10.** Verfahren nach einem der vorangegangenen Ansprüche,
**dadurch gekennzeichnet, dass**
die abgetrennte Scheibe (13) auf ein weiteres Substrat aufgebracht wird.

**11.** Verfahren nach einem der vorangegangenen Ansprüche,
**dadurch gekennzeichnet, dass**
die Schichten (2a - d; 5a - d; 8a - d; 11) mit dem größten Radius mit einer Schichtdicke aus einem Bereich von 1 - 150 nm, vorzugsweise von unter 15 nm aufgebracht werden.

**12.** Verfahren nach einem der vorangegangenen Ansprüche,
**dadurch gekennzeichnet, dass**
die Schichten (2a-d; 5a-d; 8a-d; 11) abwechselnd aus $Ta_2O_5$ und $Al_2O_3$ gebildet werden.

**13.** Verfahren nach einem der vorangegangenen Ansprüche,
**dadurch gekennzeichnet, dass**
die Scheibe (13) mit einer Scheibendicke (3c, 6c, 9c) aus einem Bereich von 100 nm bis 10 $\mu$m abgetrennt wird.

## Claims

**1.** Process for producing a Fresnel zone plate (15), comprising:

- providing a substrate (1, 4, 7);
- applying consecutive layers (2a - d; 5a - d; 8a - d; 11) by means of an atomic layer deposition (ALD) process on faces (1b - c; 4b - c; 7b - c) of the substrate (1, 4, 7) without rotation of the substrate (1, 4, 7) to form a layered substrate;

wherein the substrate (1, 4, 7) is provided rotationally symmetrically with respect to its longitudinal centre axis (1a, 4a, 7a); and
the number and thickness of the individual layers is predetermined by the zone plate formula and is 100 to several hundred layers and the outermost layer has a layer thickness ranging from 5 - 30 nm, preferably below 15 nm or even down to 1 nm, **characterised in that**
the substrate (1, 4, 7) is made of glass; and a separation (3a, b; 6a, b; 9a, b) of a large number of discs (13) from the layered substrate (1, 4, 7) takes place, **in that** the layered substrate (1, 4, 7) is repeatedly divided perpendicular to the longitudinal centre axis (1a, 4a, 7a).

**2.** Process according to claim 1,
**characterised in that**

an elongate substrate (1, 4, 7), the longitudinal centre axis (1 a, 4a, 7a) of which is the centre axis, is used as the substrate, the faces being longitudinal sides (1b - c; 4b - c; 7b - c) of the elongate substrate.

**3.** Process according to claim 2,
**characterised in that**
a cylindrical element (1, 7) is used as the elongate substrate.

**4.** Process according to claim 3,
**characterised in that**
the cylindrical element (7), in the direction of its longitudinal centre axis (7a), has a centrally arranged through-opening (20).

**5.** Process according to claim 2,
**characterised in that**
a cone-shaped or truncated cone-shaped element (4) is used as the elongate substrate.

**6.** Process according to any of claims 3 to 5,
**characterised in that**
the consecutive layers (2a - d; 5a - d) are applied to the outside of the cylindrical or cone-shaped or truncated cone-shaped element (1, 4).

**7.** Process according to claim 4,
**characterised in that**
the consecutive layers (8a - d) are applied to the cylindrical element (7) with the through-opening (20) on the inside along walls (7b, 7c) of the through-opening (20).

**8.** Process according to claim 1,
**characterised in that**
a sphere or a portion thereof is used as the substrate.

**9.** Process according to any of the preceding claims,
**characterised in that**
the separated disc (13) is reduced with respect to its disc thickness (3c, 6c, 9c) by grinding and/or polishing operations.

**10.** Process according to any of the preceding claims,
**characterised in that**
the separated disc (13) is applied to a further substrate.

**11.** Process according to any of the preceding claims,
**characterised in that**
the layers (2a - d; 5a - d; 8a - d; 11) with the largest radius are applied with a layer thickness ranging from 1 - 150 nm, preferably below 15 nm.

**12.** Process according to any of the preceding claims,
**characterised in that**
the layers (2a - d; 5a - d; 8a - d; 11) are alternately formed from Ta205 and Al203.

**13.** Process according to any of the preceding claims,
**characterised in that**
the disc (13) is separated with a disc thickness (3c, 6c, 9c) from a range from 100 nm to 10 pm.

## Revendications

**1.** Procédé de fabrication d'une plaque à zones de Fresnel (15), comportant :

- la mise à disposition d'un substrat (1, 4, 7) ;
- l'application de couches successives (2a-d ; 5a-d ; 8a-d ; 11) au moyen d'un procédé de dépôt de couches atomiques (ALD) sur des faces (1b-c ; 4b-c ; 7b-c) du substrat (1, 4, 7) sans rotation du substrat (1, 4, 7) pour la formation d'un substrat revêtu ;

le substrat (1, 4, 7) étant mis à disposition en étant symétrique en rotation par rapport à son axe central longitudinal (1a, 4a, 7a) ; et
le nombre et l'épaisseur des couches individuelles étant prédéterminé par la formule des plaques zonales et s'élevant à 100 à plusieurs centaines de couches et la couche la plus à l'extérieur présentant une épaisseur de couche dans une plage de 5-30 nm, de préférence au-dessous de 15 nm ou même jusqu'à 1 nm, **caractérisé par le fait que**
le substrat (1, 4, 7) est en verre ; et une séparation (3a, b ; 6a, b ; 9a, b) d'une pluralité de tranches (13) a lieu à partir du substrat revêtu (1, 4, 7) en ce que le substrat revêtu (1, 4, 7) est divisé plusieurs fois perpendiculairement à l'axe central longitudinal (1a, 4a, 7a).

**2.** Procédé selon la revendication 1,
**caractérisé par le fait que**
comme substrat, un substrat allongé (1, 4, 7), dont l'axe central longitudinal (1a, 4a, 7a) constitue l'axe central, est utilisé, les faces constituant des côtés longitudinaux (1 b-c ; 4b-c ; 7b-c) du substrat allongé.

**3.** Procédé selon la revendication 2,
**caractérisé par le fait que**
comme substrat allongé, un élément cylindrique (1, 7) est utilisé.

**4.** Procédé selon la revendication 3,
**caractérisé par le fait que**
l'élément cylindrique (7) présente une ouverture traversante (20) disposée de façon centrale dans la direction de son axe central longitudinal (7a).

**5.** Procédé selon la revendication 2,

**caractérisé par le fait que**
comme substrat allongé, un élément conique ou tronconique (4) est utilisé.

**6.** Procédé selon l'une des revendications 3 à 5,
**caractérisé par le fait que**
les couches (2a-d ; 5a-d) successives sont appliquées sur l'élément cylindrique ou conique ou tronconique (1, 4) du côté extérieur.

**7.** Procédé selon la revendication 4,
**caractérisé par le fait que**
les couches successives (8a-d) sont appliquées sur l'élément cylindrique (7) avec l'ouverture traversante (20) du côté intérieur le long de parois (7b, 7c) de l'ouverture traversante (20).

**8.** Procédé selon la revendication 1,
**caractérisé par le fait que**
comme substrat, une sphère ou une section de celle-ci est utilisée.

**9.** Procédé selon l'une des revendications précédentes,
**caractérisé par le fait que**
la tranche séparée (13) est réduite dans son épaisseur de tranche (3c, 6c, 9c) par des opérations de meulage et/ou de polissage.

**10.** Procédé selon l'une des revendications précédentes,
**caractérisé par le fait que**
la tranche séparée (13) est appliquée sur un autre substrat.

**11.** Procédé selon l'une des revendications précédentes,
**caractérisé par le fait que**
les couches (2a-d ; 5a-d ; 8a-d ; 11) ayant le plus grand rayon avec une épaisseur de couche dans une plage de 1-150 nm, de préférence de moins de 15 nm, sont appliquées.

**12.** Procédé selon l'une des revendications précédentes,
**caractérisé par le fait que**
les couches (2a-d ; 5a-d ; 8a-d ; 11) sont formées alternativement de Ta2O5 et d'Al2O3.

**13.** Procédé selon l'une des revendications précédentes,
**caractérisé par le fait que**
la tranche (13) avec une épaisseur de tranche (3c, 6c, 9c) dans une plage de 100 nm à 10 $\mu$m est séparée.

1b
1a
1c
3a
3b
1
2a
2b
2c
2d

Fig. 1

4b
4a
4c
4
6a
6b
5a
5b
5c
5d

Fig. 2

8d
8c
8b
8a
8a
8b
8c
8d
20
9a
9b
7a
7b
7c
7
7

Fig. 3

10

Fig. 4

11
11
11
11
HV
18.00 kV
mag
49 956 x
det
TLD
WD
5.1 mm
HFW
5.12 µm
2 µm
Zonenplatte 3 dr=35 nm (Faser)

Fig. 5

13
12
HV
18.00 kV
mag
2 505 x
det
ETD
WD
5.1 mm
HFW
102 µm
40 µm
Zonenplatte 2 dr=35 nm (Faser)


Fig. 6

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente


- US 7365918 B